Europäisches Patentamt

European Patent Office

Office européen des brevets

(19)

(11) Veröffentlichungsnummer: **0 078 407**
**B1**

# EUROPÄISCHE PATENTSCHRIFT

(12)

(45) Veröffentlichungstag der Patentschrift:
**04.06.86**

(51) Int. Cl.⁴: **B 32 B  15/00,** D 21 H  3/48,
H 05 K  1/02

(21) Anmeldenummer: **82109137.8**

(22) Anmeldetag: **04.10.82**

(54) **Kupferkaschiertes Hartpapier aus einem flammwidrigen Schichtpressstoff.**

(30) Priorität: **30.10.81  DE 3143121**

(43) Veröffentlichungstag der Anmeldung:
**11.05.83 Patentblatt 83/19**

(45) Bekanntmachung des Hinweises auf die Patenterteilung:
**04.06.86 Patentblatt 86/23**

(84) Benannte Vertragsstaaten:
**AT BE CH DE FR GB IT LI LU NL SE**

(56) Entgegenhaltungen:
**DE - A - 2 426 862
FR - A - 1 560 178
FR - A - 2 412 581
GB - A - 1 468 065
GB - A - 1 497 154**

**CHEMICAL ABSTRACTS, Band 96, Nr.4, 23.Jan.1982,
Seite 44, Zusammenfassung Nr.21039s, Columbus, Ohio
(US)**

(73) Patentinhaber: **DYNAMIT NOBEL
AKTIENGESELLSCHAFT, Postfach 1209,
D-5210 Troisdorf, Bez. Köln (DE)**

(72) Erfinder: **Franz, Arnold, Eifelstrasse 23,
D-5210 Troisdorf-Spich (DE)**
Erfinder: **Köpnick, Siegfried, Langemarckstrasse 14a,
D-5210 Troisdorf (DE)**

## Beschreibung

Die Erfindung betrifft ein kupferkaschiertes Hartpapier aus einem flammwidrigen Schichtpressstoff auf Basis eines cellulosehaltigen Trägermaterials und eines Imprägnierlackes aus einem Phenol-Resol mit Zusätzen von Weichmachern.

Derartige Schichtpressstoffe auf Basis von Phenol-Resol-Harzen, teilweise mit Epoxid-Zusatz oder auf Basis von Kresol-Resol-Harzen, die mit Holzölen modifiziert sind, werden im Falle des Phenol-Resol-Harzsystems mit Phosphorsäureester als Weichmacher in grossen Mengen hergestellt.

Während die mechanische und elektrische Qualität und die Flammwidrigkeit der auf dieser Basis hergestellten Kupfer-Hartpapiere voll zufriedenstellen, können von diesen Systemen noch nicht alle Anforderungen hinsichtlich verbesserter Kaltstanzbarkeit, verringerter Rissbildung, insbesondere bei der Herstellung von Lochgruppen für integrierte Schaltkreise, sowie vernachlässigbarer Lochverstopfung erfüllen.

Bei der weiteren Untersuchung dieser Eigenschaften wurde festgestellt, dass die besten Werte hinsichtlich der Kaltstanzbarkeit beim Kaltstanzen von Löchern mit 0,8 mm Durchmesser ohne Lochverstopfung und bei gleichzeitiger Erfüllung der Norm IEC 249-2-7 FVO am besten von bei der Harzherstellung durch Anlagerung von Holzöl, Leinöl oder Fettsäuren weichgemachten Resolen erreicht werden. Die Herstellung solcher Harze ist jedoch vergleichsweise aufwendig und solche Harze sind für Einfachimprägnierungen nicht geeignet.

Der Erfindung liegt die Aufgabe zugrunde, ein kupferkaschiertes Hartpapier mit verbesserter Kaltstanzbarkeit und niedriger erforderlicher Stanzkraft ohne Lochverstopfung bei Erfüllung physikalischer Eigenschaften entsprechend IEC 249-2-7 FVO vorzuschlagen.

Diese Aufgabe wird erfindungsgemäss entsprechend den im Kennzeichen des Anspruches 1 angegebenen Merkmalen gelöst.

Bevorzugt ist nach Anspruch 2 ein kupferkaschiertes Hartpapier, bei dem der Imprägnierlack innerhalb der folgenden Zusammensetzungsbereiche liegt

| | |
|---|---|
| ammoniakalisch kondensiertes | |
| Phenolresolharz | von 40 bis 42, |
| niedermolekulares Phenolharz | |
| | von 8 bis 12, |
| Diphenylkresylphosphat | von 28 bis 32, |
| Hexamethylentetramin | von 1 bis 4, |
| Tetrabrombisphenol A | von 3 bis 5 |
| und | von 10 bis 20 Gew.% |

der Polyurethankomponente als einem Umsetzungsprodukt von Polyethylenglykol, Polypropylenglykol und p-Nonylphenol mit Toluol-2,4-diisocyanat.

Die erfindungsgemäss vorgeschlagene Verwendung der Polyurethankomponente verleiht den so modifizierten kupferkaschierten Hartpapieren auf Basis des bezeichneten Phenolresolharzsystems eine überlegene Kaltstanzbarkeit. Ferner ist die von der Stanzvorrichtung aufzubringende, auf eine Nadel bezogene Kraft zum Herausziehen der Stanznadel aus dem Laminat ebenfalls erheblich vermindert. Mit den erfindungsgemäss aus polyurethanmodifizierten Phenolresolharzsystemen aufgebauten kupferkaschierten Hartpapieren konnten die Stanzkraft und die Abstreifkraft und die Geräuschentwicklung beim Stanzen erheblich reduziert und die Lebensdauer der Stanznadeln wesentlich erhöht werden.

Die erfindungsgemäss verwendete Polyurethan-Komponente reagiert mit dem beschriebenen Phenolresol und bewirkt somit eine bis dahin unbekannte Elastizität von reinen Phenolharzen, die im Anwendungsgebiet der Laminatherstellung Verwendung finden. Diese Elastizität war bisher nur an durch Holzöl, Leinöl oder Fettsäuren modifizierten Kresol-Phenolharzen bekannt. Bei der Anwendung solcher Harztypen sind verfahrenstechnische und umweltbedingte Massnahmen zu treffen, die bei Anwendung des erfindungsgemässen Vorschlags nicht in diesem Umfang erforderlich sind. Es hat sich jedoch gezeigt, dass die anzuwendenden Mengenverhältnisse der Polyurethan-Komponente und der Aufbau des Gesamtsystems durchaus kritisch hinsichtlich der übrigen technischen Anforderungen an einen Schichtpressstoff sind. Insbesondere mussten folgende Forderungen erfüllt werden:

Gute Homogenisierung des Imprägnierlacksystems mit dem Trägermaterial zwecks ausreichender Transparenz der gefertigten Laminate, innerhalb der Spezifikation liegende niedrige Wasseraufnahme, ausreichende Wärmestabilität, gute Lagenbindung und Lagerstabilität der Prepregs, Einstufung in die Brandklasse nach UL 94 VO, geringe Wölbung, wenig Schrumpfung und ausreichende Biegefestigkeit.

Zur Erreichung dieser Anforderungen wurde eine Reihe der nachfolgend diskutierten Massnahmen in Betracht gezogen. Ausgegangen wird von einem Imprägnierlack auf Basis eines Phenolresolharzsystems, gemäss DE-AS 2 426 862. Insbesondere musste der Gehalt an Hexamethylentetramin zur Vermeidung einer Unverträglichkeit mit der erfindungsgemäss verwendeten Polyurethankomponente sowie in Bezug auf die Lagerstabilität der Prepreg optimiert werden. Der Anteil an niedermolekularem Phenolresol ist massgebend für die Imprägnierwirkung und damit auch für die Spezifikation der Wasseraufnahme und dielektrischer Eigenschaften.

Ferner wurde die Hinzunahme von Epoxidharzen zur Verbesserung der Wärmestabilität in Betracht gezogen. Die Zugabe von Epoxidharzen führt allerdings wieder zu einer Erhöhung der Stanzkraft und Abstreifkraft und ferner zeigten die Prepreg mit Imprägnierlacken, die Epoxidharze enthielten, teilweise schon nach 24 Stunden Lagerzeit der imprägnierten Papiere keine ausreichende Bindung der einzelnen Prepreg beim Verpressen.

Die nachfolgenden Tabellen geben eine Übersicht über diese Zusammenhänge und enthalten ein Beispiel (Nr. 1) sowie vier Vergleichsbeispiele (Nr. 11, 12, 13, 14).

In Tabelle 1 ist als Beispiel Nr. 1 eine erfindungsgemässe Zusammensetzung angegeben, wobei auf die niedrige Stanzkraft von 380 N und die geringe Abstreifkraft von 90 N besonders hinzuweisen ist. Die Beispiele Nr. 11, 12, 13 und 14 fallen nicht unter die erfindungsgemäss beanspruchten Zusammensetzungen und sind hinsichtlich unterschiedlicher Spezifikationen nicht mehr akzeptabel.

So ist gegenüber Vergleichsbeispiel 11 eine deutliche Verbesserung der Stanzkraft und Abstreifkraft zu verzeichnen. Gegenüber Vergleichsbeispiel 12, 13 und 14 liegt zwar eine vergleichbare Stanzkraft und Abstreifkraft vor, jedoch genügen diese Zusammensetzungen nicht der Flammklasse V O und hinsichtlich der Lagerzeit der Prepregs. Darüber hinaus ist Vergleichsbeispiel 12 deutlich schlechter hinsichtlich der Wasseraufnahme und des Innenwiderstands.

Das Polyurethan der Komponente E besteht aus einem Umsetzungsprodukt von Polyethylenglykol, Polypropylenglykol und p-Nonylphenol mit Toluol-2,4-diisocyanat.

### Tabelle 1

| Rohstoffe (Feststoffanteil) | Einheit | Beispiel 1 |
|---|---|---|
| A) ammoniakalisch kondensiertes Phenolresolharz | Gew.% | 40 |
| B) niedermolekulares Phenolharz | Gew.% | 10 |
| C) Diphenylkresylphosphat | Gew.% | 30 |
| D) Epoxidharz, flüssig | Gew.% | – |
| E) Polyurethan | Gew.% | 14 |
| F) Hexamethylentetramin | Gew.% | 3 |
| G) Tetrabrombisphenol A | Gew.% | 3 |
| H) Pentabromdiphenyläther | Gew.% | – |
| I) Sonstige | Gew.% | – |

| Lösungsmittelanteil | Einheit | |
|---|---|---|
| a) Methanol | % | – |
| b) Äthanol | % | – |
| c) Aceton | % | 25 |

| Eigenschaften | Einheit | |
|---|---|---|
| 1) allgemeines Aussehen | – | sehr transparent |
| 2) Transparenz (Farbkeilmethode) | Note | 1 |
| 3) Lagenbindung | Note | 1 |
| 4) Lötbad 260°C | sec. | 30 |
| 5) $H_2O$-Aufnahme | mg | 50 |
| 6) Innenwiderstand · $10^{10}$ nach D96/23 | $\Omega$ (Ohm) | 3 |
| 7) Flammklasse | UL 94 | V O |
| 8) Lagerzeit Prepreg | Tage | > 180 |
| 9) Stanzkraft | N | 380 |
| 10) Abstreifkraft | N | 90 |
| 11) Biegefestigkeit längs | N | 145 |
| 12) Biegefestigkeit quer | N | 120 |

### Tabelle 2

Vergleichsbeispiele

| | 11 | 12 | 13 | 14 |
|---|---|---|---|---|
| A) | 61 | 50 | 39 | 40,7 |
| B) | – | – | 10 | 10 |
| C) | 33 | 30 | 30 | 30 |
| D) | – | 5 | – | – |
| E) | – | 15 | 10 | 10 |
| F) | 6 | – | – | 1 |
| G) | – | – | 3 | 4 |
| H) | – | – | 3 | – |
| I) | – | – | 5 | 4,3 |
| a) | 20 | 20 | – | – |
| b) | – | – | – | – |
| c) | – | – | 25 | 25 |
| 1) | klar, homogen | sehr transparent | leicht wolkig | sehr transparent |
| 2) | 2 | 1 | 1 | 1 |
| 3) | 1 | 1 | 1 | 1 |
| 4) | 15 | 30 | 12 | 50 |
| 5) | 45 | 90 | 50 | 40 |
| 6) | 0,5 | 0,001 | 0,9 | 10 |
| 7) | V O | HB | V 1 | V 1 |
| 8) | > 365 | 1 | 6 | 12 |
| 9) | 500 | 360 | 400 | 360 |
| 10) | 160 | 60 | 100 | 80 |
| 11) | 145 | 100 | 145 | 120 |
| 12) | 125 | 80 | 120 | 100 |

### Patentansprüche

1. Kupferkaschiertes Hartpapier aus einem flammwidrigen Schichtpressstoff auf Basis eines cellulosehaltigen Trägermaterials und eines Imprägnierlackes aus einem Phenol-Resol mit Zusätzen von Weichmachern, dadurch gekennzeichnet, dass der Imprägnierlack die folgende Zusammensetzung aufweist:

| | |
|---|---|
| ammoniakalisch kondensiertes Phenolresolharz | von 35 bis 50 |
| niedermolekulares Phenolharz | von 0 bis 12 |
| Diphenylkresylphosphat | von 20 bis 35 |
| Hexamethylentetramin | von 1 bis 6 |
| Tetrabrombisphenol A | von 0 bis 5 |
| Pentabromdiphenyläther | von 0 bis 3 |
| und | von 5 bis 20 Gew.% |

einer Polyurethan-Komponente aus einem Umsetzungsprodukt von Polyethylenglykol-Polypropylenglykol und p-Nonylphenol mit Toluol-2,4-diisocyanat mit folgender Zusammensetzung:

| | |
|---|---|
| $(-O-CH_2-CH_2-)_m$ | von 15 bis 20 |
| $(-O-CH_2-CH(CH_3)-)_n$ | von 50 bis 60 |
| Toluol-2,4-diisocyanat | von 8 bis 12 |
| Nonylphenol | von 10 bis 15 Gew.%. |

2. Kupferkaschiertes Hartpapier nach Anspruch 1, dadurch gekennzeichnet, dass der Imprägnierlack

| | |
|---|---|
| ammoniakalisch kondensiertes Phenolresolharz | von 40 bis 42 |
| niedermolekulares Phenolharz | von 8 bis 12 |
| Diphenylkresylphosphat | von 28 bis 32 |
| Hexamethylentetramin | von 1 bis 4 |
| Tetrabrombisphenol A und | von 3 bis 5 von 10 bis 15 Gew.% |

der Polyurethan-Komponente enthält.

## Claims

1. Copper laminated hard paper formed from a flame-resistant moulded laminated plastics material based on a cellulose containing support and an impregnating lacquer formed from a phenolic resol with additions of plasticisers, characterised in that the impregnating lacquer possesses the following composition:

| | |
|---|---|
| ammoniacal condensed phenolic resol resin | from 35 to 50 |
| low molecular phenolic resin | from 0 to 12 |
| diphenylcresyl phosphate | from 20 to 35 |
| hexamethylenetetramine | from 1 to 6 |
| tetrabromobisphenol A | from 0 to 5 |
| pentabromodiphenyl ether | from 0 to 3% by weight |

and from 5 to 20% by weight of a polyurethane component formed from a reaction product of polyethylene glycol-polypropylene glycol and p-nonylphenol with toluene-2,4-diisocyanate with the following composition:

| | |
|---|---|
| $(-O-CH_2-CH_2-)_m$ | from 15 to 20 |
| $(-O-CH_2-CH(CH_3)-)_n$ | from 50 to 60 |
| toluene-2,4-diisocyanate | from 8 to 12 |
| nonylphenol | from 10 to 15% by weight. |

2. Copper laminated hard paper according to claim 1, characterised in that the impregnating lacquer contains

| | |
|---|---|
| ammoniacal condensed phenolic resol resin | from 40 to 42 |
| low molecular phenolic resin | from 8 to 12 |
| diphenylcresyl phosphate | from 28 to 32 |
| hexamethylenetetramine | from 1 to 4 |

tetrabromobisphenol A from 3 to 5% by weight and from 10 to 15% by weight of the polyurethane component.

## Revendications

1. Papier bakélisé doublé de cuivre constitué d'un stratifié ignifuge à base d'un matériau de support contenant de la cellulose et d'un vernis d'imprégnation constitué d'un phénol-résol avec additions de plastifiants, caractérisé par le fait que le vernis d'imprégnation présente la composition suivante:

| | |
|---|---|
| résine de phénol-résol condensée par voie ammoniacale | de 35 à 50 |
| résine phénolique à faible poids moléculaire | de 0 à 12 |
| phosphate de diphénylcrésyle | de 20 à 35 |
| hexaméthylènetétramine | de 1 à 6 |
| tétrabromobisphénol A | de 0 à 5 |
| pentabromodiphényléther | de 0 à 3 |
| et | de 5 à 20% en poids |

d'un composant polyuréthanne constitué d'un produit de réaction du polyéthylèneglycol-polypropylèneglycol et du p-nonylphénol avec le toluène-2,4-diisocyanate ayant la composition suivante:

| | |
|---|---|
| $(-O-CH_2-CH_2-)_m$ | de 15 à 20 |
| $(-O-CH_2-CH(CH_3)-)_n$ | de 50 à 60 |
| toluène-2,4-diisocyanate | de 8 à 12 |
| nonylphénol | de 10 à 15% en poids. |

2. Papier bakélisé doublé de cuivre selon la revendication 1, caractérisé par le fait que le vernis d'imprégnation contient:

| | |
|---|---|
| résine de phénol-résol condensée par voie ammoniacale | de 40 à 42 |
| résine phénolique à faible poids moléculaire | de 8 à 12 |
| phosphate de diphénylcrésyle | de 28 à 32 |
| hexaméthylènetétramine | de 1 à 4 |
| tétrabromobisphénol A | de 3 à 5 |
| et | de 10 à 15% en poids |

du composant polyuréthanne.